# EUROPÄISCHE PATENTSCHRIFT

(11) **EP 0 414 934 B1**
(45) Veröffentlichungstag und Bekanntmachung des Hinweises auf die Patenterteilung: **27.04.1994**
(21) Anmeldenummer: 89115924.6
(22) Anmeldetag: 29.08.1989
(51) Int. Cl.: H01L 27/02

(54) **Eingangsschutzstruktur für integrierte Schaltungen**
Input protection structure for integrated circuits
Structure de protection d'entrée pour circuits intégrés

(43) Veröffentlichungstag der Anmeldung: 06.03.1991
(73) Patentinhaber: SIEMENS AKTIENGESELLSCHAFT, 80333 München (DE)
(72) Erfinder: Becker, Burkhard, Dr. rer. nat., D-8000 München 80 (DE)

(56) Entgegenhaltungen:
- GB-A- 2 176 053
- GB-A- 2 182 491
- PATENT ABSTRACTS OF JAPAN vol. 12, no. 146 (E-605)(2993) 06 Mai 1988, & JP-A-62 263670
- PATENT ABSTRACTS OF JAPAN vol. 8, no. 161 (E-257)(1598) 26 Juli 1984, & JP-A-59 61169

## Beschreibung

Die vorliegende Erfindung betrifft eine Eingangsschutzstruktur gegen elektrostatische Entladungen für integrierte Schaltungen mit den Merkmalen
- die Eingangsschutzstruktur ist zwischen einen Eingang und ein Referenzpotential geschaltet,
- in einem Halbleitersubstrat angeordnet und
- enthält mindestens einen Thyristor, der aus einem Gebiet eines ersten Leitungstyps, einem Gebiet eines zweiten Leitungstyps, einer dritten Zone des ersten Leitungstyps und einer vierten Zone des zweiten Leitungstyps gebildet ist,
- der Thyristor enthält einen Transistor, dessen Emitter von der vierten Zone, dessen Basis von der dritten Zone und dessen Kollektor vom Gebiet des zweiten Leitungstyps gebildet wird,
- die vierte Zone ist als Diffusionszone innerhalb der dritten Zone angeordnet,
- die dritte Zone ist als Diffusionszone innerhalb des Gebiets des zweiten Leitungstyps angeordnet,
- über der dritten Zone und der vierten Zone ist ein Anschluß angeordnet, über den der Eingang angeschlossen ist, so daß zwischen dem Emitter und der Basis des Transistors ein integrierter Widerstand wirkt,
- das Gebiet des ersten Leitungstyps ist an das Referenzpotential angeschlossen.

Eine solche Schutzstruktur ist in der britischen Offenlegungsschrift GB 2 182 491 gezeigt. Der zwischen Basis und Emitter des eingangsseitigen Transistors wirkende Widerstand wird nur von einem Teil des Stroms bei einer elektrostatischen Entladung durchflossen. Der andere Teil konzentriert sich auf eine relativ kleine Sperrschichtfläche, so daß dort die Gefahr eines Durchbruchs besteht. Auch bei der aus der Veröffentlichung Patent Abstracts of Japan 12 (146) (E-605) 〈2993〉 bekannten Schutzstruktur fließt nur ein Teil des Stroms durch den zwischen Basis und Emitter des eingangsseitigen Transistors wirkenden Widerstand. Auch hier besteht für den anderen Teil des Stroms die Gefahr eines Sperrschichtdurchbruchs. In der Veröffentlichung Patent Abstracts of Japan 8 (161) (E-257) 〈1598〉 ist eine Eingangsschutzstruktur gezeigt, bei der zwischen Emitter und Basis des eingangsseitigen Transistors eines Thyristors ein Widerstand gebildet ist. Der Thyristor ist durch eine laterale Anordnung von Dotierungsgebieten realisiert.

Der vorliegenden Erfindung liegt daher die Aufgabe zugrunde, eine Eingangsschutzstruktur der angegebenen Art so weiterzubilden, daß sie eine hohe Festigkeit gegenüber Sperrschichtdurchbrüchen aufweist.

Diese Aufgabe wird bei einer Eingangsschutzstruktur der angegebenen Art dadurch gelöst, daß die vierte Zone eine Aussparung, durch die die dritte Zone bis zum Anschluß reicht, aufweist.

Weiterbildungen der Erfindung sind Gegenstand von Unteransprüchen.

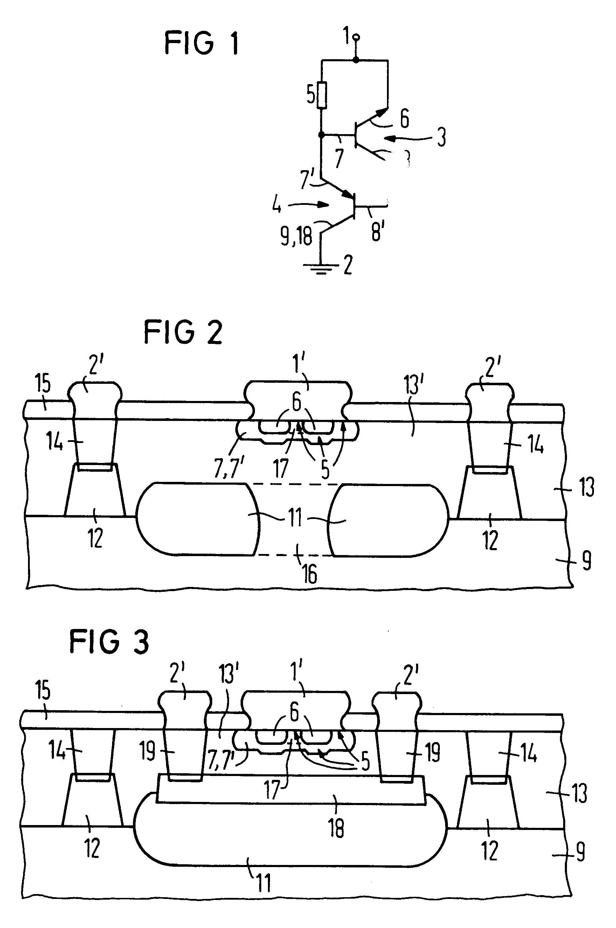

Die Erfindung wird im folgenden anhand eines Ausführungsbeispiels gemäß den FIG 1 und 2 der Zeichnung näher erläutert.
Es zeigen
- FIG 1: ein Ersatzschaltbild einer Eingangsschutzstruktur in Form eines durch zwei Transistoren gebildeten Thyristors und eines Widerstandes gemäß der Erfindung, womit ein Schutz gegen elektrostatische Entladungen beider Polaritäten möglich ist; und
- FIG 2, 3: zwei Ausführungsformen der Realisierung einer Eingangsschutzstruktur nach FIG 1 in einem Halbleitersystem in schematischer Darstellung.

Gemäß FIG 1 liegt zwischen einem Eingangsanschluß 1 einer integrierten Schaltung, insbesondere einer bipolaren integrierten Schaltung, und einem Referenzpotential 2, insbesondere Masse, eine Schutzstruktur, die durch einen ersten Transistor 3 und einen zweiten Transistor 4, welche zu einem Thyristor gekoppelt sind, und einen Widerstand 5, der zwischen Eingang 1 und Basis 7 des ersten Transistors geschaltet ist, gebildet wird. Insbesondere ist dabei der Eingang 1 mit dem Emitter 6 des ersten Transistors 3 und über den Widerstand 5 mit der Basis 7 des ersten Transistors 3 verbunden. Bei dem ersten Transistor handelt es sich vorzugsweise um einen NPN-Transistor. Der zweite vorzugsweise PNP-Transistor 4 ist mit seinem Kollektor 9, 18 an das Referenzpotential 2 angeschlossen. Seine Basis 8' ist mit dem Kollektor 8 des ersten Transistors und sein Emitter 7' mit der Basis 7 des ersten Transistors verbunden.

Die Bezugszeichen nach FIG 1 sind in Übereinstimmung mit den Bezugszeichen nach FIG 2 des im folgenden zu erläuternden Halbleitersystems gewählt, in dem die Schutzstruktur realisiert wird. Die Schutzstruktur im Halbleitersystem nach FIG 2 wird im folgenden anhand der schematischen Verfahrensabfolge bei der Herstellung erläutert.

Ausgangspunkt für die Herstellung des Halbleitersystems nach FIG 2 ist ein Halbleitersubstrat 9 eines Leitungstyps, bei dem es sich vorzugsweise um den P-Leitungstyp handelt. In dieses Halbleitersystem wird in an sich konventioneller Weise zunächst eine insbesondere hochdotierte erste Zone des entgegengesetzten Leitungstyps, im vorliegenden Beispiel also des n-Leitungstyps eindiffundiert, durch die mit den nachfolgenden Herstellungsschritten eine Buried-layer-Zone 11 gebildet wird. Gemäß der Erfindung besitzt diese erste Zone 11 im Inneren eine Aussparung 16, so daß sie eine ringförmige Gestalt aufweist. Weiterhin werden in das Halbleitersubstrat 9 Zonen mit dem Leitungstyp des Halbleitersubstrats eindiffundiert, welche ebenfalls in Verbindung mit den nachfolgenden Herstellungsschritten Teilzonen 12 eines an sich üblichen Isolationsrahmens bilden.

Anschließend wird in bekannter Weise auf das insoweit behandelte Halbleitersubstrat 9 eine epitaktische Schicht 13 mit gegenüber dem Halbleitersubstrat 9 entgegengesetztem Leitungstyp, im vorliegenden Beispiel also mit n-Leitungstyp, aufgebracht. Eine zweite Zone 13' wird dabei von dem Teil der epitaktischen Schicht 13 gebildet, der innerhalb des noch zu vervollständigenden Isolationsrahmens 12 liegt. Die erste Zone 11 bildet in Verbindung mit der zweiten Zone 13' den Kollektor 8 des ersten Transistors in FIG 1; die Basis 8' des zweiten Transistors 4 in FIG 1 wird im wesentlichen nur durch die zweite Zone 13' gebildet.

Nachfolgend werden in weiteren Diffusionsschritten Zonen 14 und eine dritte Zone 7, 7' in die epitaktische Schicht 13 eingebracht, die beide den Leitungstyp des Halbleitersubstrats 9, im vorliegenden Ausführungsbeispiel also den p-Leitungstyp, aufweisen. Dabei vervollständigen die in die Teilzone 12 hineinreichenden Zonen 14 den an sich konventionellen, die zweite und dritte Zone einschließenden Isolationsring 12, 14. Die dritte Zone 7, 7' liegt innerhalb der zweiten Zone 13' und vorzugsweise über der Aussparung 16 der ersten Zone 11. Sie bildet die Basis 7 des ersten Transistors 3 und gleichzeitig den Emitter 7' des zweiten Transistors 4.

In die dritte Zone 7, 7' wird eine vierte Zone 6 mit dem Leitungstyp der zweiten Zone, im vorliegenden Beispiel also mit n-Leitungstyp, eindiffundiert. Die vierte Zone 6 ist von der zweiten Zone 13' durch die dritte Zone 7, 7' isoliert und besitzt erfindungsgemäß eine Aussparung 17, die vorzugsweise senkrecht über der Aussparung der ersten Zone 11 angeordnet ist. Durch die Anordnung von dritter und vierter Zone wird, wie später noch erläutert wird, der integrierte Widerstand 5 gebildet.

Schließlich wird auf die Oberfläche des Halbleitersystems eine isolierende Schicht 15 aufgebracht, die zur Herstellung von Anschlußöffnungen strukturiert wird. Über einen ersten Anschluß 1' werden die vierte (6) und dritte Zone 7, 7' an den Eingang 1, über einen zweiten Anschluß 2' wird das Halbleitersubstrat 9 über den Isolationsrahmen 14, 12 an das Referenzpotential 2 angeschlossen.

Aufgrund der vorstehend erläuterten Zonenstruktur ergibt sich im Halbleitersystem ein erster NPN-Transistor 3 und ein zweiter PNP-Transistor 4. Der erste Transistor 3 wird durch die vierte Zone 6, die dritte Zone 7, 7' sowie die zweite und erste Zone 13', 11 als Emitter, Basis sowie Kollektor gebildet. Der zweite Transistor 4 wird durch die dritte Zone 7, 7', die zweite Zone 13' sowie das Halbleitersubstrat 9 als Emitter, Basis sowie Kollektor gebildet. Insgesamt stellt die Zonenfolge also einen NPNP-Thyristor dar, bestehend aus: vierter Zone 6 - dritter Zone 7, 7' - zweiter einschließlich erster Zone 13', 11 - Substrat.

Das Ersatzschaltbild eines solchen Thyristors sind bekanntlich zwei Transistoren entgegengesetzten Leitungstyps entspreche den Transistoren 3 und 4 in FIG 1, wobei die Basis des einen mit dem Kollektor des anderen verbunden ist und umgekehrt. In der Thyristorarbeitsweise der vorliegenden Schutzstruktur arbeitet der zweite Transistor 4 daher im Inversbetrieb.

Der integrierte Widerstand 5 wird durch die Dimensionierung der vierten Zone 6 innerhalb der dritten Zone 7, 7' (Pinch-Widerstand) einerseits und durch den Überlapp des Anschlusses 1' über die dritte Zone 7, 7' sowie durch die Aussparung 17 in der vierten Zone 6 andererseits gebildet.

Positive Spannungsimpulse werden über den zweiten PNP-Transistor zum Bezugspotential 2 abgeleitet. Die PNP-Transistorwirkung kompensiert hier die Thyristorwirkung. Der Thyristor befindet sich im Sperrbereich, so daß der positive Impuls den Pfad über den pnp-Transistor (Normalbetrieb) nimmt. Ein ausreichend hoher Überlapp des Anschlusses 1' über die dritte Zone 7, 7' (den Emitter 7' des zweiten Transistors 4), sowie eine nicht zu kleine Aussparung 17 in der vierten Zone 6 sorgen für einen hinreichend kleinen integrierten Eingangswiderstand 5 der Struktur. Dieser wird also durch Dimensionierung der dritten Zone 7, 7' und vierten Zone 6 einschließlich der Aussparung 17 in der vierten Zone 6 eingestellt. Die Aussparung 16 der ersten Zone 11 verkleinert die effektive Basisweite des Substrat-PNP-Transistors 4 und begünstigt eine vertikale Arbeitsweise.

Negative Spannungsimpulse werden über den Thyristor abgeleitet, der so dimensioniert wird, daß seine Haltespannung vorzugsweise nahe 0 V liegt. Der integrierte Widerstand 5 liegt hier in Form eines Pinch-Widerstandes vor, der durch die Dimensionierung der vierten Zone 6 in der dritten Zone 7, 7' eingestellt wird. Ein hoher Wert des Widerstandes ist von Vorteil, damit der Thyristor in seiner Eigenschaft als vier-Schicht-Bauelement ausgenutzt wird.

Der Widerstand 5 muß so dimensioniert werden, daß zum einen für positive Spannungen die PNP-Transistor-Wirkung voll zum Tragen kommt (kleiner Widerstandswert), zum anderen aber bei negativen Spannungen die Thyristor-Wirkung nicht behindert wird (großer Widerstandswert). Ein Kompromiß zwischen den beiden entgegengesetzten Anforderungen sichert die Einsetzbarkeit der Struktur für Spannungsimpulse beider Polaritäten. Ein Widerstandswert in der Größenordnung von 100 Ohm hat sich von Vorteil erwiesen. Der Überlapp des Anschlusses 1' über die dritte Zone 7,7' sorgt für eine laterale, die Aussparung 17 in der vierten Zone 6 für eine vertikale Komponente der Arbeitsweise. Beide Maßnahmen tragen zur Homogenisierung des Feldstärke- und Stromverlaufs bei.

Mit Hilfe der speziellen Struktur von dritter und vierte Zone wird neben der Variation der PNP- bzw. Thyristorwirkung eine Homogenisierung des Stromverlaufs (vertikale Arbeitsweise) und damit eine Erhöhung der Belastbarkeit erreicht. Zusätzlich zur vertikalen Arbeitsweise wird eine laterale Komponente zwischen der p-dotierten dritten Zone 7, 7' und den p-dotierten Zonen 12, 14 des Isolationsrahmens, die den Substratanschluß bilden, erzielt. Die Homogenisierung des Stromflusses sowie die Kombination aus lateraler und vertikaler Arbeitskomponente bieten eine hohe Belastbarkeit des Bauelementes gegen Entladungen beider Polaritäten.

Fig. 3 zeigt eine weitere Ausführungsform der erfindungsgemäßen Eingangsschutzstruktur in einem Halbleitersystem, die insbesondere bei großer Dicke der epitaktischen Schicht 13 vorteilhaft ist. Die Bezugszeichen sind in Übereinstimmung mit Fig. 2 gewählt; im folgenden werden nur die Unterschiede zur Ausführungsform gemäß Fig. 2 erläutert.

Die erste Zone 11 wird ohne Aussparung hergestellt und dient als Isolation gegenüber dem Substrat 9. Auf ihr ist eine untere Diffussionsgrenze 18, die vorzugsweise gleichzeitig mit der unteren Teilzone 12 des Isolationsrahmens hergestellt wird und den Leitungstyp des Substrats, hier also den p-Leitungstyp, aufweist. Die untere Diffussionszone 18 besitzt eine höchstens gleich große laterale Ausdehnung wie die erste Zone 11 und wird durch obere Diffusionszonen 19 mit dem Anschluß 2' verbunden. Das Substrat 9 wird nicht angeschlossen.

In dieser Ausführungsform wird der zweite PNP-Transistor 4 durch die dritte Zone 7,7' als Emitter, die zweite Zone 13' als Basis und die untere Diffusionszone 18 als Kollektor gebildet. Entsprechend wird der npnp-Thyristor aus diesen 3 Zonen sowie der davorgeschalteten vierten Zone 6 gebildet.

Der Vorteil der zweiten Ausführungsform liegt in der Nichtbelastung des Substrates 9. Die Impulse werden nicht über das Substrat abgeführt, sondern über die obere Diffusionszone 19, womit auch kurzzeitige Schwankungen des Substratpegels vermieden werden. Zum anderen wirkt sich die Struktur in Prozeßlinien mit großer Dicke der epitaktischen Schicht 13 (im Bereich von 10um) günstig aus, da hier der Ausdehnung der Sperrschichten enge Grenzen gesetzt sind, so daß Lawinendurchbrüche weitgehend unterdrückt werden.

Bei beiden Ausführungsformen ist ein zentralsymmetrischer Aufbau der Schutzstruktur besonders vorteilhaft, ein streifenförmiger ist aber ebenfalls möglich.

## Patentansprüche

1. Eingangsschutzstruktur gegen elektrostatische Entladungen für integrierte Schaltungen mit den Merkmalen:
- die Eingangsschutzstruktur ist zwischen einen Eingang (1) und ein Referenzpotential (2) geschaltet,
- in einem Halbleitersubstrat (9) angeordnet und
- enthält mindestens einen Thyristor, der aus einem Gebiet eines ersten Leitungstyps, einem Gebiet eines zweiten Leitungstyps, einer dritten Zone (7, 7') des ersten Leitungstyps und einer vierten Zone (6) des zweiten Leitungstyps gebildet ist,
- der Thyristor enthält einen Transistor (3), dessen Emitter von der vierten Zone (6), dessen Basis von der dritten Zone (7, 7') und dessen Kollektor vom Gebiet des zweiten Leitungstyps gebildet wird,
- die vierte Zone (6) ist als Diffusionszone innerhalb der dritten Zone (7, 7') angeordnet,
- die dritte Zone (7, 7') ist als Diffusionszone innerhalb des Gebiets des zweiten Leitungstyps angeordnet,
- über der dritten Zone (7, 7') und der vierten Zone (6) ist ein Anschluß (1') angeordnet, über den der Eingang (1) angeschlossen ist, so daß zwischen dem Emitter und der Basis des Transistors (3) ein integrierter Widerstand (5) wirkt,
- das Gebiet des ersten Leitungstyps ist an das Referenzpotential angeschlossen,
**dadurch gekennzeichnet**, daß die vierte Zone (6) eine Aussparung, durch die die dritte Zone (7, 7') bis zum Anschluß (1') reicht, aufweist.

2. Eingangsschutzstruktur nach Anspruch 1, **dadurch gekennzeichnet,** daß der integrierte Widerstand (5) durch den Überlapp des Anschlusses (1') über die dritte Zone (7, 7') sowie durch die Dimensionierung der dritten (7, 7') und/oder vierten Zone (6) und/oder der Aussparung (17) der vierten Zone (6) eingestellt wird.

3. Eingangsschutzstruktur nach Anspruch 1 oder 2, **dadurch gekennzeichnet,** daß das Gebiet des ersten Leitungstyps das Halbleitersubstrat (9) ist und das Gebiet des zweiten Leitungstyps durch eine erste und zweite Zone (11,13') gebildet wird.

4. Eingangsschutzstruktur nach Anspruch 1 oder 2, **dadurch gekennzeichnet,** daß das Gebiet des ersten Leitungstyps eine untere Diffusionszone (18) ist, die auf einer ersten Zone (11) angeordnet ist, und das Gebiet des zweiten Leitungstyps durch eine zweite Zone (13') gebildet wird.

5. Eingangsschutzstruktur nach Anspruch 3 oder 4, **dadurch gekennzeichnet,** daß die erste Zone (11) als vergrabene Zone ausgebildet ist.

6. Eingangsschutzstruktur nach einem der Ansprüche 3 bis 5, **dadurch gekennzeichnet**, daß die zweite Zone (13') als Teilzone einer epitaktischen Schicht (13) ausgebildet ist.

7. Eingangsschutzstruktur nach Anspruch 3, **dadurch gekennzeichnet**, daß die erste Zone (11) eine Aussparung (16) besitzt.

8. Eingangsschutzstruktur nach Anspruch 3 oder 7, **dadurch gekennzeichnet,** daß die zweite Zone (13') seitlich durch einen Isolationsrahmen bildende Diffusionszonen (12, 14) begrenzt ist.

9. Eingangsschutzstruktur nach Anspruch 8, **dadurch gekennzeichnet**, daß das Halbleitersubstrat (9) über den Isolationsrahmen (12, 14) und einen weiteren Anschluß (2') an das Referenzpotential (2) angeschlossen ist.

10. Eingangsschutzstruktur nach einem der Ansprüche 3, 7 bis 9, **dadurch gekennzeichnet,** daß ein weiterer Transistor (4) des Thyristors aus der dritten Zone (7, 7') als Emitter, der zweiten Zone (13') als Basis und dem Halbleitersubstrat (9) als Kollektor gebildet ist.

11. Eingangsschutzstruktur nach Anspruch 4, **dadurch gekennzeichnet**, daß die untere Diffusionszone (18) durch die erste Zone (11) vom Halbleitersubstrat (9) isoliert ist.

12. Eingangsschutzstruktur nach Anspruch 4 oder 11, **dadurch gekennzeichnet**, daß die untere Diffusionszone (18) über mindestens eine obere Diffusionszone (19) und einen weiteren Anschluß (2') an das Referenzpotential (2) angeschlossen ist.

13. Eingangsschutzstruktur nach einem der Ansprüche 4, 11 oder 12 , **dadurch gekennzeichnet,** daß ein weiterer Transistor (4) des Thyristors aus der dritten Zone (7, 7') als Emitter, der zweiten Zone (13') als Basis und der unteren Diffusionszone (18) als Kollektor gebildet wird.

## Claims

1. Input protection structure against electrostatic charges for integrated circuits having the features:
- the input protection structure is connected between an input (1) and a reference potential (2),
- is arranged in a semiconductor substrate (9) and
- contains at least one thyristor which is formed from a region of a first conductance type, a region of a second conductance type, a third zone (7, 7') of the first conductance type and a fourth zone (6) of the second conductance type,
- the thyristor contains a transistor (3) whose emitter is formed by the fourth zone (6), whose base is formed by the third zone (7, 7') and whose collector is formed by the region of the second conductance type,
- the fourth zone (6) is arranged, as a diffusion zone, inside the third zone (7, 7'),
- the third zone (7, 7') is arranged, as a diffusion zone, inside the region of the second conductance type,
- arranged over the third zone (7, 7') and the fourth zone (6) is a connection (1') via which the input (1) is connected, so that an integrated resistor (5) acts between the emitter and the base of the transistor (3),
- the region of the first conductance type is connected to the reference potential,
characterized in that the fourth zone (6) has a recess through which the third zone (7, 7') extends as far as the connection (1').

2. Input protection structure according to Claim 1, characterized in that the integrated resistor (5) is set by the overlap of the connection (1') over the third zone (7, 7') and by the dimensioning of the third (7, 7') and/or fourth zone (6) and/or of the recess (17) of the fourth zone (6).

3. Input protection structure according to Claim 1 or 2, characterized in that the region of the first conductance type is the semiconductor substrate (9), and the region of the second conductance type is formed by a first and a second zone (11, 13').

4. Input protection structure according to Claim 1 or 2, characterized in that the region of the first conductance type is a lower diffusion zone (18) which is arranged on a first zone (11), and the region of the second conductance type is formed by a second zone (13').

5. Input protection structure according to Claim 3 or 4, characterized in that the first zone (11) is constructed as a buried zone.

6. Input protection structure according to one of Claims 3 to 5, characterized in that the second zone (13') is constructed as a sub-zone of an epitaxial layer (13).

7. Input protection structure according to Claim 3, characterized in that the first zone (11) has a recess (16).

8. Input protection structure according to Claim 3 or 7, characterized in that the second zone (13') is bounded laterally by diffusion zones (12, 14) which form an insulation frame.

9. Input protection structure according to Claim 8, characterized in that the semiconductor substrate (9) is connected to the reference potential (2) via the insulation frame (12, 14) and a further connection (2').

10. Input protection structure according to one of Claims 3, 7 to 9, characterized in that a further transistor (4) of the thyristor is formed from the third zone (7, 7') as the emitter, the second zone (13') as the base and the semiconductor substrate (9) as the collector.

11. Input protection structure according to Claim 4, characterized in that the lower diffusion zone (18) is insulated from the semiconductor substrate (9) by the first zone (11).

12. Input protection structure according to Claim 4 or 11, characterized in that the lower diffusion zone (18) is connected to the reference potential (2) via at least one upper diffusion zone (19) and a further connection (2').

13. Input protection structure according to one of Claims 4, 11 or 12, characterized in that a further transistor (4) of the thyristor is formed from the third zone (7, 7') as the emitter, the second zone (13') as the base, and the lower diffusion zone (18) as the collector.

## Revendications

1. Structure de protection d'entrée vis-à-vis de décharges électrostatiques pour des circuits intégrés, présentant les caractéristiques suivantes :
- la structure de protection d'entrée est branchée entre une entrée (1) et un potentiel de référence (2),
- est disposée dans un substrat semiconducteur (9), et
- comporte au moins un thyristor, qui est formé d'une région d'un premier type de conduction, d'une région d'un second type de conduction et d'une troisième zone (7, 7') du premier type de conduction et d'une quatrième zone (6) du second type de conduction,
- le thyristor comporte un transistor (3), dont l'émetteur est formé par la quatrième zone (6), dont la base est formée par la troisième zone (7, 7') et dont le collecteur est formé par la région du second type de conduction,
- la quatrième zone (6) est disposée en tant que zone de diffusion dans la troisième zone (7, 7'),
la troisième zone (7, 7') est disposée en tant que zone de diffusion dans la région du second type de conduction,
- au-dessus de la troisième zone (7, 7') et de la quatrième zone (6) est disposée une borne (1'), au moyen de laquelle l'entrée (1) est raccordée de sorte qu'une résistance intégrée (5) agit entre l'émetteur et la base du transistor (3),
- la région du premier type de conduction est raccordée au potentiel de référence,
caractérisée par le fait que la quatrième zone (6) comporte un évidement, par lequel la troisième zone (7, 7') s'étend jusqu'à la borne (1').

2. Structure de protection d'entrée suivant la revendication 1, caractérisée par le fait que la résistance intégrée (5) est réglée par le chevauchement de la borne (1') sur la troisième zone (7, 7') ainsi que par le dimensionnement de la troisième zone (7, 7') et/ou de la quatrième zone (6) et/ou de l'évidement (17) de la quatrième zone (6).

3. Structure de protection d'entrée suivant la revendication 1 ou 2, caractérisée par le fait que la région du premier type de conduction est le substrat semiconducteur (9) et la région du second type de conduction est formée par une première et une seconde zones (11, 13').

4. Structure de protection d'entrée suivant la revendication 1 ou 2, caractérisée par le fait que la région du premier type de conduction est une zone inférieure de diffusion (18), qui est disposée sur une première zone (11), et que la région du second type de conduction est formée par une seconde zone (13').

5. Structure de protection d'entrée suivant la revendication 3 ou 4, caractérisée par le fait que la première zone (1) est sous la forme d'une zone ensevelie.

6. Structure de protection d'entrée suivant l'une des revendications 3 à 5, caractérisée par le fait que la seconde zone (13') est sous la forme d'une zone partielle d'une couche épitaxiale (13).

7. Structure de protection d'entrée suivant la revendication 3, caractérisée par le fait que la première zone (11) possède un évidement (16).

8. Structure de protection d'entrée suivant la revendication 3 ou 7, caractérisée par le fait que la seconde zone (13') est délimitée latéralement par des zones de diffusion (12, 14) qui forment un cadre isolant.

9. Structure de protection d'entrée suivant la revendication 8, caractérisée par le fait que le substrat semiconducteur (9) est raccordé par l'intermédiaire du cadre isolant (12, 14) et d'une autre borne (2') au potentiel de référence (2).

10. Structure de protection d'entrée suivant l'une des revendications 3, 7 à 9, caractérisée par le fait qu'un autre transistor (4) du thyristor est formé par la troisième zone (7, 7') en tant qu'émetteur, par la seconde zone (13') en tant que base et par le substrat semiconducteur (9) en tant que collecteur.

11. Structure de protection d'entrée suivant la revendication 4, caractérisée par le fait que la zone inférieure de diffusion (18) est isolée du substrat semiconducteur (9) par la première zone (11).

12. Structure de protection d'entrée suivant la revendication 4 ou 11, caractérisée par le fait que la zone inférieure de diffusion (18) est raccordée par l'intermédiaire d'au moins une zone supérieure de diffusion (12) et d'une autre borne (2') au potentiel de référence (2).

13. Structure de protection d'entrée suivant l'une des revendications 4, 11 ou 12, caractérisée par le fait qu'un autre transistor (4) du thyristor est formé par la troisième zone (7, 7') en tant qu'émetteur, par la seconde zone (13') en tant que base et par la zone inférieure de diffusion (18) en tant que collecteur.
